# EUROPEAN PATENT APPLICATION

(11) **EP 4 375 725 A1**
(43) Date of publication of application: **29.05.2024**
(21) Application number: 22209783.4
(22) Date of filing: 28.11.2022
(51) Int. Cl.: G02B 26/00, G02B 5/28

(54) **EVACUATED OPTICAL CAVITY**

(71) Applicant: Alpine Quantum Technologies GmbH, 6020 Innsbruck (AT)
(72) Inventor: FELDKER, Thomas, 6020 Innsbruck (AT); Monz, Thomas, 6103 Reith b. Seefeld (AT)
(74) Representative: Grünecker Patent- und Rechtsanwälte PartG mbB

(57) **Abstract**

The present disclosure provides embodiments for optical cavity apparatuses and methods for assembling such apparatuses. For instance, an optical cavity apparatus comprises a body and two mirrors that are attached to the body and form an optical cavity having an optical path inside the body. Furthermore, the body has an opening that allows gas to be pumped out of the optical cavity; and comprises a closing means attached to the opening that can be closed for maintaining, after pumping the gas out of the optical path, a negative pressure in the optical cavity.

## Description

### TECHNICAL FIELD

Embodiments of the present invention relate to the field of optical cavities.

### BACKGROUND

The frequency (or the emission spectrum) of a laser is usually prone to fluctuations due to experimental imperfections and environmental disturbances acting on the laser device. This may lead to a drift of the laser frequency(s) (i.e. a shift of the emission spectrum over time) as well as to a broadening of the line width(s) (i.e. a broadening of the emission spectrum at each given time).

There are, however, many technical applications (e.g., quantum computing, quantum simulations, atomic and molecular experiments, spectroscopy, magnetic sensors, atomic clocks, etc.) that require high-quality laser light with. For instance, the fidelity of some laser-based gate implementations in quantum information processors depend strongly on the emission spectrum of the employed laser (e.g. when using trapped ions to represent qubits and performing quantum operation using laser beams). More specifically, some high-fidelity gates require ultra-narrow laser linewidths (e.g. a linewidth <1Hz), a high-frequency stability (e.g. a frequency drift of < 1Hz over 1s), and low phase noise in a wide frequency range around the center frequency (e.g. 50-5000kHz around the center frequency).

### SUMMARY

Accordingly, there may be need to improve the provision of high-quality laser light.

The invention is defined by the independent claims. Some of the advantageous embodiments are subject matter to the dependent claims.

According to an embodiment, an optical cavity apparatus is provided. The optical cavity apparatus comprises a body having an opening and two mirrors attached to the body. More specifically, the two mirrors form an optical cavity with an optical path inside the body. Furthermore, the opening allows gas to be pumped out of the optical cavity, and the optical cavity apparatus comprises, attached to the opening, closing means that can be closed for maintaining, after pumping the gas out of the optical path, a negative pressure in the optical cavity.

Details of one or more embodiments are set forth in the accompanying drawings and the description below. Other features, objects, and advantages will be apparent from the description, drawings, and claims.

### BRIEF DESCRIPTION OF THE DRAWINGS

In the following embodiments of the invention are described in more detail with reference to the attached figures and drawings, in which:
- Fig. 1: is an optical beat note measurement representing the combined phase noise of two ultra-narrow linewidth lasers.
- Fig. 2: is a schematic two-dimensional drawing illustrating an optical cavity apparatus provided within an evacuated chamber;
- Fig. 3: is a schematic two-dimensional drawing illustrating an optical cavity apparatus having a spacer with opening and closing means for providing the vacuum;
- Fig. 4: is a schematic three-dimensional drawing illustrating an optical cavity apparatus having a spacer with opening and closing means for providing the vacuum;
- Fig. 5: is a schematic exploded-view drawing of an optical cavity apparatus having a spacer with opening and closing means for providing the vacuum;
- Fig. 6: is a schematic drawing illustrating the assembled state of the optical cavity apparatus of Fig. 4; and
- Fig. 7: is a flowchart illustrating exemplary steps for assembling an optical cavity apparatus.

It is to be expressly understood, however, that the drawings are for the purpose of illustration and description only and are not intended as a definition of the limits of the disclosed subject matter. Furthermore, it is noted that identical reference signs refer to identical or at least functionally equivalent features.

### DETAILED DESCRIPTION

In the following description, reference is made to the accompanying figures, which form part of the disclosure, and which show, by way of illustration, specific aspects of embodiments of the invention or specific aspects in which embodiments of the present invention may be used. It is understood that embodiments of the invention may be used in other aspects and comprise structural or logical changes not depicted in the figures. The following detailed description, therefore, is not to be taken in a limiting sense, and the scope of the present invention is defined by the appended claims.

It is understood that the features of the various exemplary embodiments and/or aspects described herein may be combined with each other, unless specifically noted otherwise.

For purposes of the description hereinafter, the terms "end," "upper," "lower," "right," "left," "vertical," "horizontal," "top," "bottom," "lateral," "longitudinal," and derivatives thereof shall relate to the disclosed subject matter as it is oriented in the drawing figures. However, it is to be understood that the disclosed subject matter may assume various alternative variations and step sequences, except where expressly specified to the contrary. It is also to be understood that the specific devices and processes illustrated in the attached drawings, and described in the following specification, are simply exemplary embodiments or aspects of the disclosed subject matter. Hence, specific dimensions and other physical characteristics related to the embodiments or aspects disclosed herein are not to be considered as limiting unless otherwise indicated.

No aspect, component, element, structure, act, step, function, instruction, and/or the like used herein should be construed as critical or essential unless explicitly described as such. Also, as used herein, the articles "a" and "an" are intended to include one or more items and may be used interchangeably with "one or more" and "at least one." Furthermore, as used herein, the term "set" is intended to include one or more items (e.g., related items, unrelated items, a combination of related and unrelated items, and/or the like) and may be used interchangeably with "one or more" or "at least one." Where only one item is intended, the term "one" or similar language is used. Also, as used herein, the terms "has," "have," "having," or the like are intended to be open-ended terms. Further, the phrase "based on" is intended to mean "based at least partially on" unless explicitly stated otherwise.

### Embodiments

In general, an optical resonator or optical cavity, or etalon (comprising two parallel mirrors) may be used to stabilize a laser to a particular frequency and/or to *"filter"* the laser light emitted by a laser. More specifically, when entering an optical resonator, light of most frequencies will be suppressed due to destructive interference. Only light of some specific frequencies, also referred to as resonant/resonance frequencies, will experience constructive interference and be sustained (*"survive"*) in the resonator.

For instance, the spectrum of lasers may be improved (*"filtered'*) by sending the light through an optical resonator, which when used in this way is also referred to as optical filter or filter cavity. Only parts of the light that (sufficiently) meet the resonance condition of the cavity can pass it and hence unwanted frequency components (sufficiently far) away from the central laser frequency can be suppressed. Thus, in general, a filter cavity may be used to reduce the linewidth and/or to reduce phase noise.

More specifically, the linewidth is defined as the width of the frequency range (around the center frequency) at which the power of the laser beam is larger than half its maximum value, which the laser beam has at its center frequency (i.e. full width at half maximum or width at -3 decibel carrier (dBc)). Accordingly, the linewidth does not specify (i.e. is not related to) noise at frequencies far away from the central frequency. Such noise at far-away (e.g. 50-5000kHz away) frequencies is here also referred to as phase noise.

In typical scenarios, a filter cavity filters/suppresses frequencies more than 100kHz away from the central frequency. If a narrow-width laser beam (e.g. with a linewidth of 100mHz-10Hz) is filtered with such a cavity filter, the filter cavity may thus be used to reduce the phase noise, while leaving the linewidth of the laser beam unchanged.

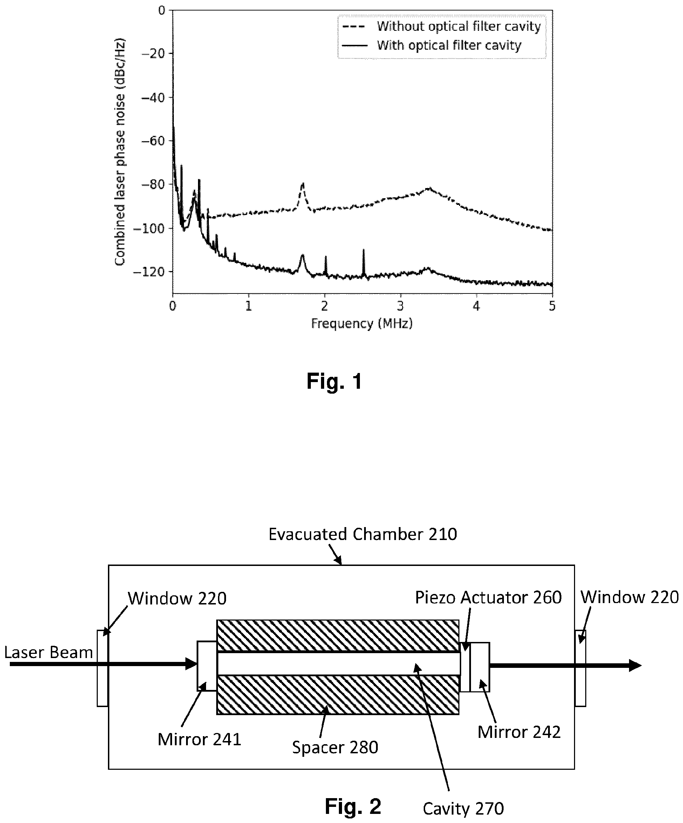

For instance, when diode laser systems are stabilized to ultra-narrow laser linewidths of <1Hz, the diode laser systems typically have non-negligible phase noise around the cut-off frequency of their stabilization electronics. More specifically, the phase-noise of such a stabilized diode laser may be -90dBc/Hz in frequency range of 300-5000kHz around the center frequency of the laser. The phase noise in the frequency range >100kHz can be efficiently reduced using an optical filter cavity. In order to reduce the phase noise below e.g. -100dBc/Hz, a filter cavity that suppresses frequencies more than 100kHz away from the central frequency may then be used, as illustrated in Fig. 1.

More specifically, **Fig.1** shows two measurements (with and without filter cavity) of the Power-Spectral-Density (PSD) of a beat note obtained by superposing a diode laser with a Ti:Sa laser (both having a narrow linewidths <~1Hz). In detail, the solid line corresponds to the measured PSD of said beat note in units of dBc/Hz (vertical axis) vs. the frequency in units of MHz (horizontal axis) when using a filter cavity; and the dashed line corresponds to a similar PSD measurement when not using a filter cavity (i.e. when not sending the superposition beam trough a filter cavity before the measurement).

It is noted that, although the PSD, shown in Fig. 1, of the beat note corresponds to the combined phase-noise of the diode laser and the Ti:Sa laser, the PSD of the beat note essentially corresponds to the phase-noise of the diode laser at least above 300kHz=0,3MHz, since the phase-noise of the Ti:Sa laser is intrinsically small in the range >300kHz. The Ti:Sa laser may thus be used as reference for the phase-noise of the diode laser.

In the frequency range >300kHz, the measured PSDs of the beat note correspond to the phase-noise of the diode laser when using a filter cavity (solid line) and when not using a filter cavity (dashed line), respectively. As can thus be seen that the filter cavity suppresses the phase-noise of the diode laser by ca 20-35dB in the range of 1-5MHz, i.e. suppresses the phase-noise from around -90dBc/Hz without filter cavity to around 120dBc/Hz with filter cavity.

It is further noted that the frequency indicated by the horizontal axis is the frequency difference from the (center) frequency of the beat note, which is given by the difference between the center frequencies of the two lasers (which is several of 10 MHz). In particular, in Fig. 1, the 0MHz position of the horizontal axis corresponds to the beat note frequency, and only one side of the Power-Spectral-Density, i.e. only the power at frequencies higher than the center frequency is shown.

In general, the length of a filter cavity may be actively stabilized using a length-adjustable element (e.g. using the PDH locking method as further explained below), so that a resonant frequency of the cavity corresponds to the center frequency of the laser beam.

Furthermore, laser light may be fed to an optical resonator and the resulting light, reflected and/or transmitted by the optical cavity, may be measured. Based on such measurements, a drift of the laser frequency may be detected and a corresponding error signal may be generated as feedback for the laser so as to adjust parameters of the laser and to counteract the laser drift. For instance, the Pound-Drever-Hall (PDH) locking method may be used to stabilize/lock the frequency of a laser to a resonant frequency of a resonator.

An exemplary optical cavity apparatus that may be used for laser filtering and/or stabilization is illustrated in **Fig. 2****.** As illustrated in Fig. 2, the optical cavity apparatus comprises two mirrors 241 and 242 that are attached to the spacer 280 and from an optical cavity. Furthermore, an optical cavity apparatus may comprise a piezo actuator 260 for adjusting the distance between the two mirrors, and thereby the optical path length and the resonant frequency(s) of the optical cavity.

Furthermore, to reduce the distortion of light in the cavity 270, the optical cavity apparatus of Fig. 2 is provided within a vacuum providing structure, e.g. an evacuated chamber 210, which, for instance, is made of steel. The chamber 210 has two light-transparent (e.g. transparent for visible light) windows 220 e.g. at opposite sides that allow laser light to be fed into the optical cavity as well to obtain light reflected and transmitted by the optical cavity. The mirrors 241 and 242 may be attached to the spacer 280 non-hermitically, so that the cavity 270 can be evacuated together with the chamber 210. Thus, light fed into the cavity propagates through the vacuum in the spacer, which may reduce absorption and/or distortion of the light in the cavity.

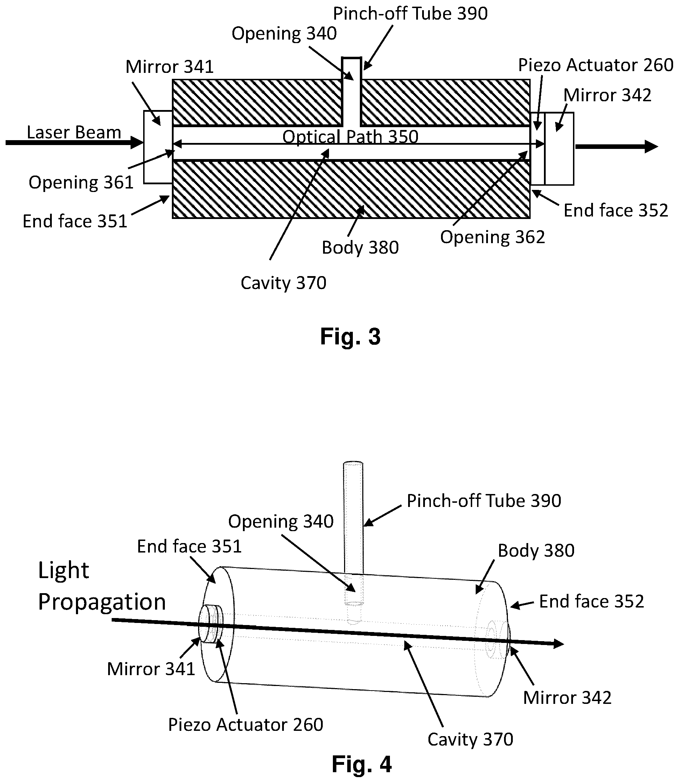

However, providing a vacuum chamber may be expensive, cumbersome, and/or space-consuming. Therefore, according to an exemplary embodiment, an optical cavity apparatus for laser filtering and/or stabilization is provided. As illustrated e.g. in **Fig. 3 to 6****,** said optical cavity apparatus comprises
(i) a body 380 having an evacuation opening 340;
(ii) closing means 390 (e.g. a pinch-off tube) attached to the evacuation opening 340; and
(iii) two (or more) mirrors 341, 342 attached to the body 380.

Here, the term *"body"* or *"spacer"* refers to the entity that keeps the mirrors at a fixed distance with respect to each other ("fixed" up to temperature fluctuation and the like, as explained in the following).

In general, the body may be made of any material. However, in order to keep the optical path length independent of changes in the temperature of the environment surrounding the optical cavity, the spacer may be made (e.g. substantially) of material(s) with a low coefficient of thermal expansion. Furthermore, a spacer material with a high damping, elastic modulus, and/or high stiffness may reduce changes of the resonant frequency(s) due to environmental disturbances. For instance, a glass, e.g. ultra-low expansion glass (ULE), in particular Zerodur may be used.

In general, the body is not limited to any particular form or shape. For instance, the body may have a cylindrical form, as illustrated e.g. in Fig. 4. For instance, the spacer may have a cylindrical form with a length of 100mm and a diameter of 40mm. In particular, the spacer may have to two parallel end faces 351 and 352, e.g. the outer surface sides of the spacer may include two surfaces 351 and 352 which are (substantially) flat and parallel with respect to each other.

The mirrors are attached to the body so that they form an optical cavity within the body (at least substantially within, but not necessarily completely within). As a specific example, two mirrors with a finesse of 10000 @A=729nm and a diameter of ½" (i.e. 1/2 inch = 1,27cm) may be used. However, the present invention is not limited to any particular type of mirror.

For instance, the mirrors may be attached at opposite sides of the body. In particular, as shown in Fig. 3 to 6, each of the mirrors may be attached to a respective one of the two parallel end faces (i.e. the top and bottom surface of the cylindrical form).

In general, the mirrors may be attached directly to the body, in particular to respective end faces of the body, i.e. without another component between them and the body (up to e.g. glue holding the mirrors and the body together). However, instead of being attached directly to the spacer, one or all of the mirrors may also be attached/fixed directly to some other physical entity/component that is inserted between the mirrors and the body. Said other component may have an optical function (e.g. a lens), or may be a length adjustable-element as discussed herein.

Since the optical cavity formed by the two mirrors is within the body, the optical path of light propagating between the mirrors is (substantially) enclosed by/inside the body. More specifically, as illustrated in Fig. 3 to 6, the body may have a cavity 370 that
(i) extends along and, in particular, includes the optical path 350 within the body 380 (e.g. includes the part of the optical path 350 that is inside the body 380); and/or
(ii) allows light to propagate between the mirrors 341, 342 within the body 380.

Here, the cavity 370 refers to free or empty space (e.g. free of solid spacer material) enclosed by the body 380.

It is noted that, as shown on the right hand side of Fig. 3, the optical cavity formed by the mirrors may extend (e.g. slightly) outside the body 380, e.g. if a length-adjustable element is inserted between the body and one of the mirrors (as the piezo actuator 260 in Fig. 3). A (usually small) part of the optical path 350 may thus extend outside the body 380, and/or not the entire optical path 350 between the mirrors is necessarily inside the body 380. In other words, the optical path 350 may include a part that is inside the body 380 and a part that is outside the body 380, in the following referred to as inside and outside part, respectively.

In general, the outside part may be hermetically connected (i.e. gas exchange between inside and outside part is possible) to (i) the cavity 370 and/or (ii) the inside part, where, to be specific, hermetically connected means that gas/air exchange between the inside and the outside part is possible. Thus, said outside part is hermetically sealed by the body 380 (and e.g. by the mirrors, glue, and closing means) from the outside environment together with the inside part. Furthermore, as shown in Fig. 3, the two ends of the optical path 350 are where the mirrors are attached to the body. To be specific, one end of the optical path is corresponds to the (inner) surface of a first of the mirrors, and the other end of the optical path corresponds to the (inner) surface of a second of the mirrors (other than the first mirror). In general, as illustrated in Fig. 3, the optical path may be a straight line between the mirrors. Thus, the optical path may end at opposite sides of the body (e.g. at/near the mentioned end faces 351 and 352). In particular, in case the body 380 has a cylindrical form as illustrated in Fig. 3 to 6, the optical path 350 may be parallel to the longitudinal axis of said cylindrical form. It is however noted that, in particular in case of a resonator formed by more than two mirrors, the geometrical length of the optical path may not be a straight line.

As further illustrated in e.g. Figs. 3 and 4, light may enter and/or leave the optical cavity through one or both of the mirrors. To this end, the body may have one or two openings 361, 362, and the mirrors may be attached on top of said openings 361, 362 as illustrated in Fig. 3 to 6. Light may then enter or leaving the optical path/cavity through the respective mirror and opening. To be specific, in Fig. 3 to 6, light may enter/leaving the optical cavity e.g. (i) through mirror 341 and opening 361, and/or or (ii) through mirror 342 and opening 362. The openings 361 and 362 are thus at/near the ends of the optical path 350 and, in particular, may be at the end faces 351 and 352, respectively.

Here it is to be noted the openings 361 and 362, through which light may pass, are different openings than the opening 340 (here also referred to as *"evacuation opening")* for pumping gas out of the cavity 370. In particular, the openings 361 and 362 are hermetically sealed, e.g. by gluing the mirrors 341 and 342 to the body 380 on top of the openings 361 and 362.

The evacuation opening 340 allows (if not sealed by the closing means as discussed below) gas to be pumped out of the cavity, in particular out of the optical cavity formed by the two mirrors 341,342 and/or out of the optical path 350. For instance, in case the body 380 has a cylindrical form as illustrated in Fig. 3 to 6, the evacuation opening 340 may be on a side surface of the cylindrical form, but may in general by on any side of a cylindrical or non-cylindrical body 380. In general, the evacuation opening may be any connection from the surface of the body to the cavity that allows to evacuate the cavity. For instance, the evacuation opening 340 may be a bore or hole extending, from a surface of the spacer 380 to the cavity 370.

Furthermore, as illustrated in Fig. 3 to 6, the optical cavity apparatus is provided with closing means 390, attached to the evacuation opening 340. In other words, the closing means 390 are attached to the body 380 so that gas entering or leaving the cavity 370 through the evacuation opening 340 passes through the closing means 390. In other words, the closing means 390 is attached airtight/hermetically sealing to the body 380 so that gas can enter or leave the cavity 370 through the evacuation opening 340 only via the closing means 390.

In general, the closing means 390 may have an open and a closed state. When the closing means is in the open state, gas can pass through the closing means and the evacuation opening 340. In this state, the evacuation opening 340 can thus be used to pump gas out of the cavity. When the closing means is in the closed state, the closing means prevents gas from passing through the evacuation opening 340. Thus, the closing means can be closed for maintaining, after pumping the gas (e.g. air) out of the optical path and/or the cavity, negative pressure in the optical cavity. Regarding this, it is noted that negative pressure refers to a lower/negative pressure with respect to the outside environment of the spacer (e.g. below atmospheric pressure; in general the amount of desired underpressure may depend on the application).

More specifically, since the openings(s) for input/output of light are also hermetically sealed, the closing means may be used (by closing it) to hermetically seal the evacuation opening and, thus, the cavity 370 from the atmosphere outside the body.

While maintaining the vacuum within the cavity, light fed into the cavity propagates through the vacuum in the spacer, which may reduce absorption and/or distortion of the light in the cavity. Providing the vacuum with the spacer, i.e. hermetically sealing the cavity after evacuation, allows for a compact, vacuum-spaced cavity. Using an evacuation opening and a closing means allows for a simple and cost-efficient way to generate and maintain the vacuum with the spacer. In particular, usage of an expensive and/or big vacuum chamber as shown in Fig. 2 may be avoided. The vacuum may also prevent dust from floating in the cavity and degrading the mirrors, in particular when permanently sealing the cavity e.g. by using pinch-off tube as closing means as discussed below.

In general, the sealing/closing of (i.e. the change from the open to the closed state) of the closing means 390 may be *"reversible"* or *"irreversible",* where reversible refers to closing means designed to allow for multiple switches between the open and closed state, and *irreversible* to a closing designed for just one transition from the open to the closed state.

For instance, the closing means may also be an air/gas valve that can be: (i) opened for pumping gas out of the optical cavity, and (ii) closed for maintaining, after pumping the gas out of the optical cavity, a negative pressure inside the optical cavity. Using a valve may be a more flexible solution than a more permanent closing means as it may allow to easily open the valve and change the pressure inside the cavity to a different value.

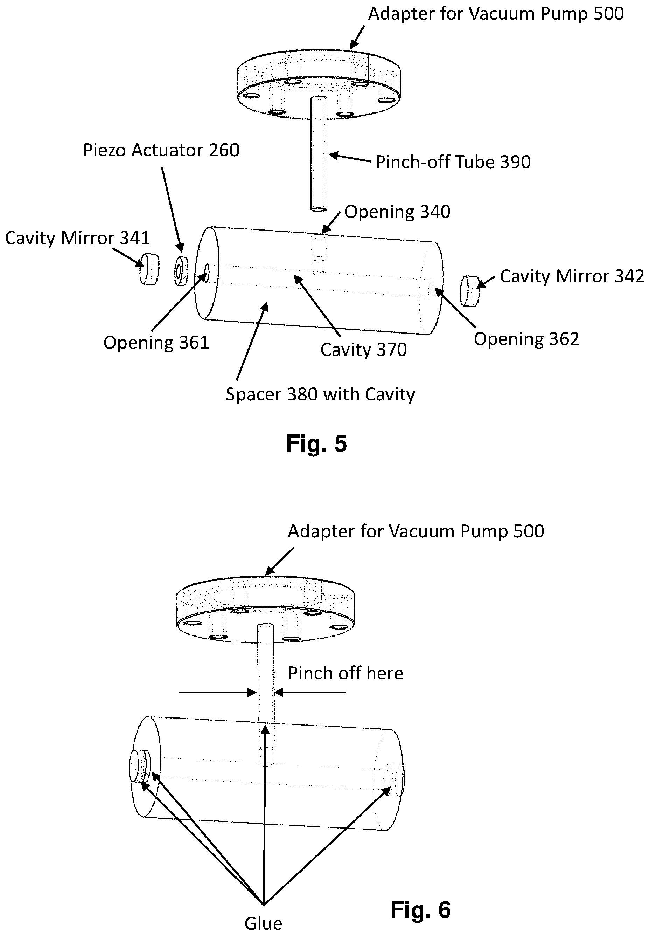

However, the present invention is not limited to a reversible. For instance, the closing means may e.g. be a pinch-off tube, which is usually a (small) tube or pipe, e.g. made of copper or aluminum. A pinch-off tube can be hermetically sealed by pinching it off, i.e. a pinch-off tube that is *"pinched* off" is in its closed state. This off-pinching can be done, as indicated in Fig. 6, by applying pressure to the pinch-off tube using available pinch-off tool(s) and, thus, may allow for particularly simple and cost-efficient way to implement the present invention. Using a pinch-off tube may also provide a more air-tight sealing in comparison to a valve.

In general, an optical cavity apparatus with a pinch-off tube as closing means may be provided with the:
- (i) pinch-off tube in the open state (and un-evacuated chamber/cavity), or
- (ii) pinch-off tube in the closed/sealed state and a cavity with underpressure.

Providing the optical cavity apparatus with the pinch-off tube in the open state may allow for more flexibility as the amount of underpressure may set/decided later. Providing the optical cavity apparatus with a pinched-off pinch-off tube and evacuated cavity, on the other hand, may allow to use the optical cavity without equipment for evacuating and performing the pinch-off.

It is further noted that, as illustrated in Fig. 6, the closing means (e.g. the pinch-off tube) may be provided with or be used as an adapter/connector 500 for establishing a connection to a vacuum pump.

In general, as also illustrated in Fig. 3 (between the body and the right mirror 342) and Figs. 4 to 6 (between the body and the left mirror 341), the optical cavity apparatus may further comprise a length-adjustable element for adjusting the distance between the two mirrors. For instance, the length-adjustable element may be a piezo element or a piezo actuator, e.g. a ring piezo with max stroke (i.e. maximum length change) > 729nm/2.

More specifically, the term length-adjustable element refers to an element (i.e. a physical entity) the length of which can be changed in a controlled way (e.g. by applying a voltage as in case of a piezo element). By changing the length or dimensions of the length-adjustable the distance between the mirrors and, thus, the length of the optical path within the cavity can be changed. For instance, as illustrated in Fig. 3 to 6, the length-adjustable element may be attached/located between one of the mirrors and the spacer (to be specific, in Fig. 3, the piezo element 260 is attached between the body 380 and the right mirror 342; and in Fig. 4 to 6, the piezo element 260 is attached between the body 380 and the left mirror 341).

By adjusting the optical path length the resonance wavelength(s) of the optical cavity can be tuned/adjusted to particular frequency(s) e.g. using the PDH locking method to lock the cavity to a highly-stable reference laser (i.e. the cavity length rather than the reference laser is adjusted based on the PDH error signal). When using the optical cavity apparatus as an optical filter, a length-adjustable element may thus be used for adjusting a resonant frequency of the optical cavity apparatus to the frequency of the light that is to be filtered. By feeding light into the optical cavity, narrow-linewidth light with the resonant frequency may then be obtained, as only light very close to a resonant frequency is transmitted through the optical cavity.

### Assembling Method

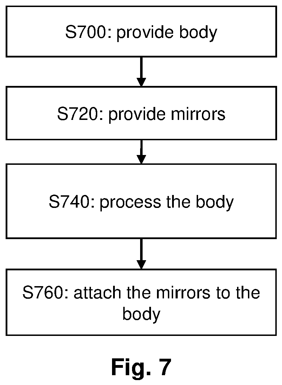

According to another exemplary embodiment, a method for assembling an optical cavity apparatus as described above with respect to Fig. 3 to 6 is provided. As illustrated in Fig. 7, the method comprises a step of providing S700 a body; and a step of providing the two mirrors S720.

The assembling method further comprises a step of processing S740 the body. In this step, the cavity 370, the two openings 361 and 362, and the evacuation opening 340 are produced. The cavity 370 is produced such that it includes the (predetermined) optical path to be formed by attaching the two mirrors at predetermined positions to the body. It is noted that said predetermined positions usually correspond to the position of the two openings 361 and 362 on the surface of the body. In general, the cavity and the bores may be generated/produced by boring, drilling and/or grinding.

The assembling method further comprises a step S760, in which are the two mirrors are attached at the predetermined positions to the body so that light leaving/entering the cavity through the openings 361 and 362 passes through a respective one of the two mirrors. The mirrors may e.g. be attached to the body by using a glue, e.g. TorrSeal, or by a laser-welding process, in which the components (i.e. mirrors and/or body) are welded together by locally heating them.

In general, the assembling method may further comprise the step of a providing the closing means 390 (e.g. a pinch-off tube), and a step of (hermetically) attaching the closing means to the evacuation opening 340.

Alternatively or in addition, the assembling method may also comprise a steps of providing a length-adjustable element, and a step of attaching the length-adjustable element to the body. For instance, the length-adjustable element may be attached to the body before attaching one of the mirrors, and said one mirror may then be attached to the body by attaching the mirror to the length-adjustable element.

In general, the closing means and the length-adjustable element, if any, may be attached to the body in the same way as used for attaching the mirrors, i.e. by using a glue (e.g. TorrSeal) or by a laser-welding process. In particular, the closing means and the length-adjustable element are attached hermetically as well.

Thus, after the two mirrors and the closing means (as well as the length-adjustable element, if any) have been attached/glued to the spacer, the bore (i.e. cavity 370) in the spacer is sealed from the surrounding atmosphere. More specifically, the only opening at this time the closing means (pinch-off tube), or a pump adapter provided/attached at the end of the closing means.

Accordingly, in case the closing means is a pinch-off tube, the assembling method may further comprise a step of pumping the air out of the (optical) cavity via the pinch-off tube, and a step of pinching off the pinch-off tube, thereby detaching the cavity from the pump 500 and hermetically sealing/maintaining the vacuum inside the filter from the environment (cf. also Fig. 6).

### Further Aspects

The embodiments and exemplary implementations mentioned above show some non-limiting examples. It is understood that various modifications may be made without departing from the claimed subject matter. For example, modifications may be made to adapt the examples to new systems and scenarios without departing from the central concept described herein.

Summarizing the above, the present disclosure provides embodiments for optical cavity apparatuses and methods for assembling such apparatuses. For instance, an optical cavity apparatus comprises a body and two mirrors that are attached to the body and form an optical cavity having an optical path inside the body. Furthermore, the body has an opening that allows gas to be pumped out of the optical cavity; and comprises a closing means attached to the opening that can be closed for maintaining, after pumping the gas out of the optical path, a negative pressure in the optical cavity.

According to a first aspect, an optical cavity apparatus is provided. The optical cavity apparatus comprises: (i) a body having an opening, (ii) closing means attached to the opening, and (iii) two mirrors attached to the body. The two mirrors form an optical cavity having an optical path inside the body; the opening allows gas to be pumped out of the optical cavity; and the closing means can be closed for maintaining, after pumping the gas out of the optical path, a negative pressure in the optical cavity.

According to a second aspect, provided in addition to the first aspect the closing means is a pinch-off tube.

According to a third aspect provided in addition to the second aspect, the optical cavity is evacuated, the pinch-off tube is pinched off, and the optical cavity is sealed from an atmosphere outside the body.

According to a fourth aspect provided in addition to the first aspect, the closing means is a valve that can be: (i) opened for pumping gas out of the optical cavity, and (ii) closed for maintaining, after pumping the gas out of the optical cavity, a negative pressure inside the optical cavity.

According to a fifth aspect, provided in addition to any of the first to the fourth aspect, optical cavity apparatus a length-adjustable element for adjusting a distance between the two mirrors.

According to a sixth aspect, provided in addition to any of the first to the fifth aspect, the body has a cylindrical form, and the optical path is parallel to a longitudinal axis of the cylindrical form.

According to a seventh aspect provided in addition to the sixth aspect, the opening is on a side surface of the cylindrical form.

According to an eighth aspect provided in addition to any of the first to the seventh aspect, (i) a first mirror of the two mirrors is attached to the body at a first end of the optical path so that light can enter and/or leave the optical path through the first mirror, and/or (ii) a second mirror of the two mirrors is attached to the body at a second end of the optical path so that light can enter and/or leave the optical path through the second mirror.

According to a ninth aspect provided in addition to any of the first to the eighth aspect, (i) the body has, at the first end of the optical path, a first other opening through which light passes when entering or leaving the optical path through the first mirror; (ii) and/or the body has, at the second end of the optical path, a second other opening through which light passes when entering or leaving the optical path through the second mirror.

According to a tenth aspect provided in addition to any of the first to the ninth aspect, the two mirrors are attached at opposite sides of the body.

According to an eleventh aspect a method for assembling an optical cavity apparatus is provided. The method comprises the steps of: (i)providing a body; (ii) providing two mirrors; (iii) processing the body to have: (a) a cavity that includes an optical path to be formed by attaching the two mirrors at predetermined positions to the body, and (b) an opening that allows gas to be pumped out of the cavity after the two mirrors are attached at the predetermined positions to the body; and (iv) attaching the two mirrors at the predetermined positions to the body, thereby making the cavity an optical cavity having the optical path inside the body.

According to a twelfth aspect provided in addition to the eleventh aspect, the method further comprises the steps of: (i) providing a pinch-off tube; and (ii) attaching the pinch-off tube to the opening.

According to a thirteenth aspect, provided in addition to the twelfth aspect, the method further comprises the steps of: (i) pumping air out of the optical cavity via the pinch-off tube; and (ii) pinching off the pinch-off tube, thereby sealing the optical cavity from an atmosphere outside the body and maintaining a negative pressure in the optical cavity.

According to a fourteenth aspect, provided in addition to any of the eleventh to the thirteenth aspect, the method further comprises the steps of: (i) providing a length-adjustable element; and (ii) attaching the length-adjustable element to the body; wherein, in the attaching of the two mirrors to the body, a mirror of the two mirrors is attached to the body by attaching the mirror to the length-adjustable element so that a distance between the two mirrors can be adjusted by adjusting a length of the length-adjustable element.

## Claims

1. An optical cavity apparatus comprising:
a body (380) having an opening (340),
closing means (390) attached to the opening (340), and
two mirrors (341, 342) attached to the body (380); wherein
the two mirrors (341, 342) form an optical cavity having an optical path (350) inside the body (380),
the opening (340) allows gas to be pumped out of the optical cavity, and
the closing means (390) can be closed for maintaining, after pumping the gas out of the optical path (350), a negative pressure in the optical cavity.

2. The apparatus according to claim 1, wherein
the closing means (390) is a pinch-off tube (390).

3. The apparatus according to claim 2, wherein
the optical cavity is evacuated,
the pinch-off tube (390) is pinched off, and
the optical cavity is sealed from an atmosphere outside the body (380).

4. The apparatus according to claim 1, wherein
the closing means is a valve that can be:
- opened for pumping gas out of the optical cavity, and
- closed for maintaining, after pumping the gas out of the optical cavity, a negative pressure inside the optical cavity.

5. The apparatus according to any of claims 1 to 4, further comprising:
a length-adjustable element (260) for adjusting a distance between the two mirrors (341, 342).

6. The apparatus according to any of claims 1 to 5, wherein
the body (380) has a cylindrical form, and
the optical path (350) is parallel to a longitudinal axis of the cylindrical form.

7. The apparatus according to claim 6, wherein
the opening (340) is on a side surface of the cylindrical form.

8. The apparatus according to any of claims 1 to 7, wherein
a first mirror (341) of the two mirrors (341, 342) is attached to the body (380) at a first end of the optical path (350) so that light can enter and/or leave the optical path (350) through the first mirror (341), and/or
a second mirror (342) of the two mirrors (341, 342) is attached to the body (380) at a second end of the optical path (350) so that light can enter and/or leave the optical path (350) through the second mirror (342).

9. The apparatus according to any of claims 1 to 8, wherein
the body (380) has, at the first end of the optical path (350), a first other opening (361) through which light passes when entering or leaving the optical path (350) through the first mirror (341); and/or
the body (380) has, at the second end of the optical path (350), a second other opening (362) through which light passes when entering or leaving the optical path (350) through the second mirror (342).

10. The apparatus according to any of claims 1 to 9, wherein
the two mirrors (341, 342) are attached at opposite sides of the body (2380).

11. A method for assembling an optical cavity apparatus, comprising:
providing (S700) a body (380);
providing (S720) two mirrors (341, 342);
processing (S740) the body (380) to have:
- a cavity that includes an optical path (350) to be formed by attaching the two mirrors (341, 342) at predetermined positions to the body (380), and
- an opening (340) that allows gas to be pumped out of the cavity after the two mirrors (341, 342) are attached at the predetermined positions to the body (380);
attaching (S760) the two mirrors (341, 342) at the predetermined positions to the body (380), thereby making the cavity an optical cavity having the optical path (350) inside the body (380).

12. The method according to claim 11, further comprising:
providing a pinch-off tube (390), and
attaching the pinch-off tube (390) to the opening (340).

13. The method according to claim 12, further comprising:
pumping air out of the optical cavity via the pinch-off tube (390), and
pinching off the pinch-off tube (390), thereby sealing the optical cavity from an atmosphere outside the body (380) and maintaining a negative pressure in the optical cavity.

14. The method according to any of claims 11 to 13, further comprising:
providing a length-adjustable element (260), and
attaching the length-adjustable element (260) to the body (380); wherein,
in the attaching of the two mirrors (341, 342) to the body (380), a mirror (341, 342) of the two mirrors (341, 342) is attached to the body (380) by attaching the mirror (341, 342) to the length-adjustable element (260) so that a distance between the two mirrors (341, 342) can be adjusted by adjusting a length of the length-adjustable element (260).

## Amended claims

### Amended claims in accordance with Rule 137(2) EPC.

1. An optical cavity apparatus comprising:
a body (380) having an opening (340);
two mirrors (341, 342) that are attached to the body (380) and form an optical resonator having an optical path (350) inside the body (380), wherein
the opening (340) allows gas to be pumped out of the optical resonator; and
a pinched-off pinch-off tube (390) attached to the opening (340) that seals the optical resonator from an atmosphere outside the body (380) and maintains a vacuum in the optical resonator.

2. The apparatus according to claim 1, further comprising:
a length-adjustable element (260) for adjusting a distance between the two mirrors (341, 342).

3. The apparatus according to claim 1 or 2, wherein
the body (380) has a cylindrical form, and
the optical path (350) is parallel to a longitudinal axis of the cylindrical form.

4. The apparatus according to claim 3, wherein
the opening (340) is on a side surface of the cylindrical form.

5. The apparatus according to any of claims 1 to 4, wherein
a first mirror (341) of the two mirrors (341, 342) is attached to the body (380) at a first end of the optical path (350) so that light can enter and/or leave the optical path (350) through the first mirror (341), and/or
a second mirror (342) of the two mirrors (341, 342) is attached to the body (380) at a second end of the optical path (350) so that light can enter and/or leave the optical path (350) through the second mirror (342).

6. The apparatus according to any of claims 1 to 5, wherein
the body (380) has, at the first end of the optical path (350), a first other opening (361) through which light passes when entering or leaving the optical path (350) through the first mirror (341); and/or
the body (380) has, at the second end of the optical path (350), a second other opening (362) through which light passes when entering or leaving the optical path (350) through the second mirror (342).

7. The apparatus according to any of claims 1 to 6, wherein
the two mirrors (341, 342) are attached at opposite sides of the body (2380).

8. A method for assembling an optical cavity apparatus, comprising:
providing (S700) a body (380);
providing (S720) two mirrors (341, 342);
processing (S740) the body (380) to have:
- a cavity that includes an optical path (350) to be formed by attaching the two mirrors (341, 342) at predetermined positions to the body (380), and
- an opening (340) that allows gas to be pumped out of the cavity after the two mirrors (341, 342) are attached at the predetermined positions to the body (380);
attaching (S760) the two mirrors (341, 342) at the predetermined positions to the body (380), thereby making the cavity an optical resonator having the optical path (350) inside the body (380), further comprising:
providing a pinch-off tube (390); and
attaching the pinch-off tube (390) to the opening (340);
pumping air out of the optical resonator via the pinch-off tube (390); and
pinching off the pinch-off tube (390), thereby sealing the optical resonator from an atmosphere outside the body (380) and maintaining a vacuum in the optical resonator.

9. The method according to claim 8, further comprising:
providing a length-adjustable element (260), and
attaching the length-adjustable element (260) to the body (380); wherein,
in the attaching of the two mirrors (341, 342) to the body (380), a mirror (341, 342) of the two mirrors (341, 342) is attached to the body (380) by attaching the mirror (341, 342) to the length-adjustable element (260) so that a distance between the two mirrors (341, 342) can be adjusted by adjusting a length of the length-adjustable element (260).
